# EUROPÄISCHE PATENTSCHRIFT

(11) **EP 3 794 338 B1**
(45) Veröffentlichungstag und Bekanntmachung des Hinweises auf die Patenterteilung: **15.02.2023**
(21) Anmeldenummer: 19722779.6
(22) Anmeldetag: 27.03.2019
(51) Int. Cl.: G01N 23/2257

(54) **MEGAELEKTRONENVOLT-BASIERTE IONENSTRAHL-ANALYTIKANLAGE**
MEGAELECTRONVOLT-BASED ION BEAM ANALYSIS APPARATUS
DISPOSITIF D'ANALYSE DE FAISCEAU IONIQUE À BASE DE MEGAÉLECTRONVOLT

(30) Priorität: 18.05.2018 DE 102018004020
(43) Veröffentlichungstag der Anmeldung: 24.03.2021
(73) Patentinhaber: Forschungszentrum Jülich GmbH, 52425 Jülich (DE)
(72) Erfinder: MÖLLER, Sören, 52399 Merzenich (DE); HÖSCHEN, Daniel, 52066 Aachen (DE); KURTH, Sina, 52388 Nörvenich (DE); HILLER, Albert, Martin, 52457 Aldenhoven (DE); SCHOLTYSIK, Christian, 53881 Euskirchen (DE); ESSER, Gerwin, 52428 Jülich-Güsten (DE); LINSMEIER, Christian, 50181 Bedburg (DE)
(86) Internationale Anmeldenummer: PCT/DE2019/000083
(87) Internationale Veröffentlichungsnummer: WO 2019/219103

(56) Entgegenhaltungen:
- JP-A- H03 257 751
- JP-A- H07 288 094
- JP-A- H09 210 927
- JP-A- H10 256 328
- Steffen Jankuhn: "Praktikumsanleitung Ionenstrahlen", , 2015, XP55609873, Gefunden im Internet: URL:https://bloch.physgeo.uni-leipzig.de/d ownload/0/0/1866172111/056a06ff9416b777bcc b0960048dfa9d9052be22/fileadmin/exp2.physg eo.uni-leipzig.de/nfp/uploads/dokumente/Le hre/IS1/WS201516/AnleitungIS-WS201516.pdf

## Beschreibung

Die Erfindung bezieht sich auf das Gebiet der Materialanalytik mit Hilfe der lonenstrahl-Mikroskopie, insbesondere für die quantitative und lokale Analyse der Zusammensetzung von Proben.

### Stand der Technik

Aus der Literatur sind zahlreiche Analyseverfahren zur Ermittlung der Zusammensetzungen einer Materialprobe bekannt. Für die qualitativen und quantitativen Analysen ist dabei insbesondere die lonenstrahlanalytik geeignet.

Die lonenstrahlanalytik (IBA) umfasst eine Vielzahl von Methoden, die unterschiedliche Partikelstrahlen mit Energien in der Größenordnung von einigen MeV einsetzen, um einzelne Konzentrationen einer Materialzusammensetzung in der Nähe, d. h. in einem Tiefenbereich von ca. 10 µm, einer Probenoberfläche zu untersuchen und zu analysieren. Die Methode arbeitet in den meisten Fällen nicht destruktiv und benötigt keine Referenzen. Mit ihr erhält man Tiefenprofile von Elementen oder Isotopen, als absolute Mengen oder auch als Konzentrationsangaben, wenn man sie mit Computer basierten Interpretationen kombiniert. Ferner ermöglicht die lonenstrahlanalytik zusammen mit Scanverfahren eine µm genaue Auflösung für kompositorische (element- und isotopenaufgelöste) Tomographien. Aus diesem Grund erstrecken sich die Anwendungen der lonenstrahlanalytik von der Malerei, über die Dünnschichttechniken bis hin zur Materialentwicklung, wobei jede Anwendung jeweils ihre besonderen Anforderungen an den Aufbau der Analytik stellt.

In der Regel werden die Untersuchungen aufgrund der schädlichen Auswirkungen der Atmosphäre auf lonenstrahlen in einer Vakuumkammer durchgeführt. Die Untersuchungen basieren auf der Detektion derjenigen Produkte, die durch die Wechselwirkung der zu untersuchenden Probe mit dem lonenstrahl generiert werden. Dies können Sekundärelektronen, γ-Strahlen, Röntgenstrahlen, gestreute Projektile oder Produkte aus einer Kernreaktion sein. Es stehen verschiedene Techniken zur Verfügung, um die in diesen Produkten enthaltenen Informationen zu nutzen. Durch die Kombination parallel detektierter unterschiedlicher Produkte können vorteilhaft eindeutige Ergebnisse erzielt werden ^{[1]}

Die nukleare Reaktionsanalyse (NRA), die Rutherford-Rückstreu-Spektrometrie (RBS) und die Partikel-induzierte Röntgenemission (PIXE), die auch als Total-IBA^{[2]} bezeichnet wird, stellt ferner eine geeignete Kombination an Analytik-tools dar, die eine besonders geringe Mehrdeutigkeit und eine unkomplizierte Integration ermöglichen.

Die Partikel-induzierte Röntgenemission bzw. Proton-induzierte Röntgenemission (engl. particle induced X-ray emission bzw. proton induced X-ray emission, PIXE) ist beispielsweise eine verbreitete Methode der lonenstrahlanalytik. Bei der PIXE wird die Probe mit einem lonenstrahl untersucht. Beim Durchlaufen der Probe verlieren die Ionen hauptsächlich durch Wechselwirkung mit der Elektronenhülle der Zielteilchen Energie. Dabei kommt es auch zu Stößen der Teilchen mit Elektronen der inneren Schalen. Dadurch werden diese aus der Atomhülle herausgeschlagen und in der Folge kann es zu einer Abregung des Kerns durch eine charakteristische Röntgenstrahlung kommen. Diese wird bei der PIXE zur Bestimmung der Elementkonzentration benutzt. Die Methode selbst ist besonders für schwere Elemente geeignet (Ordnungszahlen Z > 12...20) und hat im Vergleich zu anderen Röntgenmethoden einen deutlich geringeren Bremsstrahlungsuntergrund. Dadurch ist es auch möglich, Spurenelemente zu analysieren.

Auch die Nukleare Reaktionsanalyse (engl. nuclear reaction analysis, NRA) dient der Untersuchung von Materialzusammensetzungen. Bei der NRA wird die Probe mit einem lonenstrahl einer Energie meist im Bereich von 100 keV bis zu mehreren 10 MeV beschossen. Zur Materialanalyse werden Kernreaktionen genutzt, die durch Wechselwirkung des Teilchenstrahls mit den Probenatomen entstehen und α-, Protonen- und/oder γ-Strahlung abgeben. Entsprechend der Reaktion hat die Strahlung jeweils eine bestimmte scharf definierte Energie. Sofern der eingesetzte lonenstrahl passend zum zu detektierenden Isotop gewählt wurde, können vorteilhaft die Konzentrationen einzelner Isotope der Oberflächenschicht einer Probe gemessen werden.

Die NRA eignet sich zur Untersuchung der Oberfläche von Proben. Die analysierbare Tiefe steigt mit der Strahlenergie und sinkt mit der Ordnungszahl der lonen. Sie hängt auch in geringerem Maß von der Probenzusammensetzung ab. In der Regel beträgt sie einige Mikrometer. Da mit einer bestimmten Strahlenergie und lonensorte in der Regel nur ein oder wenige Elemente gemessen werden können, sind in der Regel zusätzliche Analysen mit anderen Verfahren notwendig, um die Probe vollständig zu charakterisieren.

Das Verfahren eignet sich durch seine Isotopenselektivität besonders zum Nachweis von Spurenelementen, aber auch zur Analyse von Prozessen mittels bestimmter Tracerisotope. Es wird vor allem für den Nachweis leichter Elemente wie Wasserstoff oder Lithium genutzt.

Auch die Rutherford-Rückstreu-Spektrometrie (engl. Rutherford backscattering spectrometry, RBS), ist eine Methode zur Untersuchung von oberflächennahen dünnen Schichten mit Hilfe von lonenstrahlen. Für eine Messung werden hochenergetische Ionen (0,1 bis 4 MeV) niedriger Masse (Wasserstoff oder Helium) auf eine Probe geschossen. Ein Detektor misst die Energie der rückgestreuten Ionen. Deren Energie hängt vom ursprünglichen Energiebetrag, von der Masse des jeweils getroffenen Probenatoms und vom Winkel unter dem detektiert wird ab. Aufgrund der Tiefenabhängigkeit der Energie der rückgestreuten Teilchen ist die Messung der Zusammensetzung einer Probe mittels RBS auch tiefenaufgelöst, wobei in Abhängigkeit von den Versuchsparametern Tiefen von einigen hundert Nanometern bis hin zu wenigen Mikrometern untersucht werden können.

Die Untersuchung der Materialzusammensetzung einer Probe mittels lonenstrahlanalytik (engl. ion beam analysis, IBA) ist daher inzwischen bereits eine Standardmethode geworden. Die Kombination aus PIXE-, NRA- und RBS-Untersuchungen führt insofern bereits zu einer nahezu kompletten Analytik aller Elemente des Periodensystems mit nur einer Messung. Eine solche Kombination zeigt beispielsweise eine Detektionsgrenze im ppm-Bereich und eine Genauigkeit im sub-%-Bereich für leichte (NRA), mittelschwere (PIXE) und schwere (PIXE + RBS) Elemente in einer konsistenten Art, die besonders vorteilhaft ist, verglichen mit einer herkömmlichen Elektronenstrahlanalytik. Diese Vorteile sind dabei besonders für die Materialforschung interessant, bei der häufig Elemente des gesamten Periodensystems in einer Probe mit stark verschiedenen Konzentrationen vorkommen.

Bei vielen lonenstrahl-Mikroskopen wird die sogenannte "Beam scanning" Technik für die Vermessung der Probenoberfläche verwendet, die aber eine weniger genaue Ortskalibration als ein Verfahren der Probe bei konstantem lonenstrahl ermöglicht. Unter "Beam scanning" wird im Allgemeinen das Rastern der Strahlposition auf der Probe durch elektromagnetische Ablenkung verstanden.

Die laterale Auflösung bei der lonenstrahlanalytik wird definiert durch den lonenstrahlquerschnitt auf der Oberfläche der Probe (spot size). Mit lonenstrahlen, bei denen typischerweise Protonen- oder Heliumionen von 1 bis 10 MeV eingesetzt werden, ist eine Fokussierung des lonenstrahls über Quadrupolmagnete, die mit einem nA Strom in modernen Beschleunigern erzeugt werden, in der Größenordnung von 1 µm möglich. Bei dieser Größe stellt die Kombination von technischen Fragestellungen bezüglich der Vibrationen, des Probenscans, des Pumpens, der Probenbeobachtung und des magnetischen Streufeldes mit den Anforderungen der Detektoren und der präzisen Ausrichtung eine instrumentelle Herausforderung dar.

Die MeV Ionen basierte Vermessung von Proben stellt insofern eine wichtige alternative Messtechnik zur Elektronenmikroskopie dar, die eine Vielzahl von Verbesserungen in den Messeigenschaften und darüber hinaus eine Sensitivität für die Eigenschaften der Atomkerne innerhalb der Probe aufweist. Die Technik ist seit vielen Jahren in der Wissenschaft in Gebrauch. Aufgrund der bislang komplexen Aufbauten und hoher spezifischer Kosten konnte sie bislang jedoch nicht die gleiche wirtschaftliche Bedeutung wie die Elektronenmikroskopie erlangen.

So ist beispielsweise eine RBS/PIXE/Channeling-Messkammer bekannt, die von der Firma High Voltage Engineering Europa B.V. (HVEE) gebaut wurde und die die Bezeichnung "Gonio Model 941 Automated Endstation" trägt. In der "Praktikumsanleitung lonenstrahlen", von Steffen Jankuhn, 2015, XP55609873 (Gefunden im Internet: URL:https://bloch.physgeo.uni-leipzig.de/download/ 0/0/1 8661 721 1 1 /056a06ff9416b777bccb0960048dfa9d9052be22/fi leadmi n/ exp2.physgeo.uni-leipzig.de/nfp/uploads/dokumente/Lehre/IS1 /WS201516/ Anlei-tungIS-WS201516.pdf) heißt es wörtlich:
"Die Messkammer ist zweiteilig ausgeführt und lässt sich in einen Detektorflansch und einen Goniometerflansch unterteilen. Beide Teile sind durch ein Scharnier verbunden, dessen gro-ßer Öffnungswinkel einen optimalen Zugang zu den in der Kammer installierten Komponenten erlaubt.

Der Detektorflansch ist fest mit dem Strahlrohr des 45°-Kanals verbunden und beherbergt die Strahleintrittsblende mit Sekundärelektronenunterdrückung, den RBS-Detektor, einen Zugang für den Röntgendetektor, eine Kamera und Halogenlampe für die visuelle Probenbeobachtung sowie eine elektrische Durchführung zum Stromintegrator. Außerdem ist an diesem Flansch das Pumpsystem der Messkammer, bestehend aus Turbomolekularpumpe und Vorpumpe, angeschlossen.

Am Goniometerflansch ist das computergesteuerte Probenpositioniersystem, ausgeführt als euzentrisches Goniometer, befestigt. Faltenbälge und eine Drehdurchführung erlauben dabei eine Kippung, Drehung und Verschiebung des Probenhalters relativ zum Flansch und damit zum lonenstrahl. Zur Vereinfachung des Probenwechsels ist der Probenhalter über einen Bajonettverschluss mit dem Goniometer verbunden und kann somit leicht entnommen werden."

Weiterhin sind aus JP H03 257751 A (KOBE STEEL LTD) 18. November 1991 (1991-11-18) und JP H07 288094 A (JEOL LTD) 31. Oktober 1995 (1995-10-31) jeweils Messkammern für eine lonenstrahlanalytik-Vorrichtung bekannt, die eine lonenstrahleinleitungsöffnung zum Einleiten eines lonenstrahls mit einem großem Durchmesser oder mit einem kleinen Durchmesser selektiv entlang der gleichen Strahlachse ermöglicht und die eine Mehrfachproben-Positionierungsvorrichtung aufweisen, mit der die Proben selektiv in der Strahlungsachse positioniert werden können und vorwärts und rückwärts relativ zu der Position der Strahlachse verschoben werden können.

### Aufgabe und Lösung

Die Aufgabe der Erfindung ist es, eine Vorrichtung für eine lonenstrahlanalytik bereit zu stellen, die gegenüber dem bisherigen Stand der Technik, eine genauere und verbesserte lokale Auflösung ermöglicht. Insbesondere ist es die Aufgabe der Erfindung, die bestehende Technik der MeV-lonenstrahlanalytik, und dabei insbesondere der MeV-lonenstrahlmikro-tomographie in ihrer Handhabung, Produktivität und Kosten zu verbessern. Besonderes Augenmerk soll dabei auf die Erhöhung des Probendurchsatzes, der Messgeschwindigkeit und die Reduktion des Messvorbereitungsaufwandes bei zumindest gleichbleibender Messqualität gelegt werden.

Die Aufgabe der Erfindung wird gelöst durch eine Vorrichtung mit den Merkmalen des Hauptanspruchs.

Vorteilhafte Ausgestaltungen der Vorrichtung ergeben sich aus den darauf rückbezogenen Ansprüchen.

### Gegenstand der Erfindung

Im Rahmen der Erfindung wurde herausgefunden, dass eine neue Vorrichtung zur Durchführung von lonenstrahl-Untersuchungen vorteilhaft eine gegenüber dem bisherigen Stand der Technik genauere und verbesserte lokale Auflösung ermöglicht. Damit kann die erfindungsgemäße Vorrichtung vorteilhaft die bestehende Technik der MeV-lonenstrahlmikro-tomographie in ihrer Handhabung und Produktivität und bezüglich der Kosten verbessern.

Die technische Herausforderung dieser Erfindung ergibt sich aus dem Wunsch, vorzugsweise gleichzeitig die Messgenauigkeit, die Messeigenschaften und die Reproduzierbarkeit weiterhin nicht nur auf dem Stand der Technik zu halten sondern darüber hinaus gegebenenfalls sogar zu verbessern. Für die guten Messeigenschaften und eine hohe Ortsauflösung ist dabei insbesondere die Minimierung der Abstände von Probe zu Detektor zu lonenfokuslinse von hoher Bedeutung.

Die zu analysierenden Eigenschaften einer Probe werden zudem maßgeblich durch die Eigenschaften des verwendeten lonenstrahls beeinflusst. Es wird somit ein sehr intensiver lonenstrahl mit einem sehr kleinen Spotdurchmesser benötigt, um gute Zählstatistiken für die Genauigkeit bzw. Präzision bei hoher räumlicher Auflösung zu generieren. Diese beiden Gegensätze können durch eine lonenstrahlfokussierung zusammengebracht bzw. aufgelöst werden.

Die erfindungsgemäße Vorrichtung vereint bisherige Technik mit speziell adaptierter und neu generierter Technik. Die Vorrichtung zur Durchführung von lonenstrahl-Untersuchungen umfasst im Einzelnen eine Vakuum-Messkammer mit wenigstens einem Detektor sowie mit einer Probenbeobachtung, mit einem Anschluss der Vakuummesskammer an ein Vakuumsystem, mit einem Strahlrohr und einem Fokussiersystem zur Fokussierung des lonenstrahls, und mit einer Schleuse zur Aufnahme eines Probentransfersystems, sowie einen Probenhalter für eine oder mehrere Proben, welcher vorteilhaft auf einem Probenmanipulator angeordnet ist.

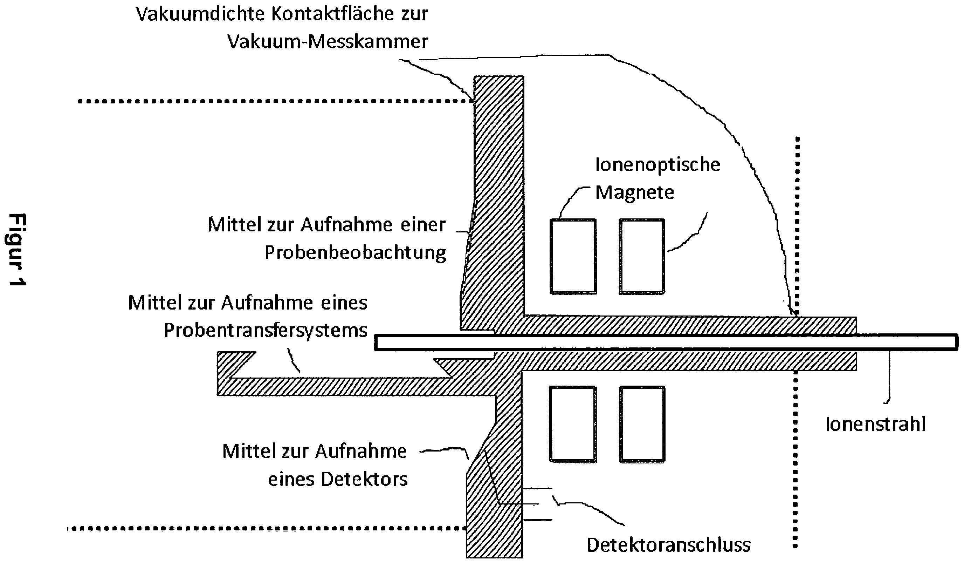

Erfindungsgemäß weist die Vorrichtung ein Einkoppelsystem für den vakuumdichten Anschluss des lonenstrahlrohres an die Vakuum-Messkammer auf, welches einerseits die lonenstrahldurchführung umfasst, gleichzeitig aber auch wenigstens ein Mittel zur Aufnahme für den wenigstens einen Detektor vorsieht. Zudem weist das Einkoppelsystem ein Mittel zur Aufnahme einer Probenbeobachtung sowie ein Mittel zur Aufnahme eines Probentransfersystems auf. Die Figur 1 zeigt schematisch ein solches Einkoppelsystem.

Das erfindungsgemäße Einkoppelsystem ermöglicht eine direkte - und vorzugsweise einteilige - mechanische Verbindung zwischen den aktiven Bauteilen lonenoptik, Detektor, Probenbeobachtung und Probentransfersystem. Das kompakte Einkoppelsystem ermöglicht vorteilhaft geringere Abstände zwischen den aktiven Bauteilen, als bislang bei den bekannten Vorrichtungen möglich war, und damit und eine reproduzierende und präzise Ausrichtung zwischen den vorgenannten aktiven Bauteilen.

Zur Vorrichtung zur Durchführung von lonenstrahl-Untersuchungen gehört als Kernidee der Erfindung ein vorzugsweise einteiliges Einkoppelsystem, welches einerseits die Einkopplung des fokussierten lonenstrahls in die Vakuum-Messkammer auf eine Probe ermöglicht, und dafür gleichzeitig auch das Probentransfersystem, die Probenbeobachtung und Detektion umfasst. Das Einkoppelsystem ermöglicht somit eine direkte Verbindung dieser aktiven Bauteile und eine vakuumdichte Verbindung mit dem Rest des Systems.

Das Einkoppelsystem für den vakuumdichten Anschluss des lonenstrahlrohres an die Messkammer umfasst neben einer lonenstrahlvakuumdurchführung, wenigstens ein Mittel zur Aufnahme für einen Detektor, ein Mittel zur Aufnahme einer Probenbeobachtung sowie ein Mittel zur Aufnahm eines Probentransfersystems, und ermöglicht vorteilhaft besonders geringe Abstände und eine präzise Ausrichtung zwischen dem letzten ionenoptischen Bauteil des Fokussiersystems, der zu untersuchenden Probe und dem Detektor.

In einer ersten Ausführungsvariante ist das Mittel zur Aufnahme einer Probenbeobachtung eine ebene Fläche, auf der ein Beobachtungsspiegel angeordnet und fixiert ist.

In einer zweiten Ausführungsvariante ist das Mittel zur Aufnahme einer Probenbeobachtung eine Halterung für eine hochauflösende Kamera.

Ebenso kann das Mittel zur Aufnahme für einen Detektor einfach eine Halterung sein, an die ein Detektor angeschlossen und fixiert werden kann.

Das Mittel zur Aufnahm eines Probentransfersystems kann beispielsweise ein Schiene sein, auf die ein Probentransfersystem leicht angeordnet werden kann.

In weiteren besonders vorteilhaften Ausführungen der Erfindung werden ferner ein optimiertes Vakuumsystem, ein optimiertes Fokussiersystem und ein optimiertes Probentransfersystem beschrieben, die jeweils einzeln oder auch in beliebigen Kombinationen eine weitere deutliche Verbesserung der bisherigen und der erfindungsgemäßen Analytikanlagen bewirken.

Die Vakuummesskammer und die Strahllinie mit dem Fokussiersystem sind dabei regelmäßig auf einem vibrationsentkoppelten Tisch angeordnet.

Die Vakuum-Messkammer weist einen Anschluss an ein Vakuumsystem auf. Das Vakuumsystem dient der Erzeugung eines Unterdrucks in der Messkammer. Für die MeV-lonen strahlmikro-tomographie werden beispielsweise Drücke im Bereich von 10⁻³ bis 10⁻⁷ Pa benötigt, wobei ein Druck < 10⁻⁵ Pa für optimale Messeigenschaften anzustreben ist. Dabei sind der Probenwechsel und die danach benötigte Abpumpzeit mit ihrem Einfluss auf die Produktivität bzw. Messbereitschaft der Anlage bei der Auslegung des Vakuumsystems zu berücksichtigen.

Zur Reduktion der elektro-magnetischen Streufelder wird die Verwendung nicht-magnetischer Vakuumbauteile und angepasster Abstände der Vakuumtechnik zur Probenposition vorgeschlagen. Als nicht-magnetische Materialien können somit vorzugsweise spezielle Edelstähle, Aluminium, Kupfer, Kunststoffe und andere Speziallegierungen eingesetzt werden. Insbesondere für lonenstrahlblenden können hitzebeständige, nicht-magnetische Materialien wie Tantal und Wolfram zum Einsatz kommen. Dabei muss erfindungsgemäß bei Temperaturschwankungen die relative Wärmeausdehnung aller Komponenten berücksichtigt werden um die relative Ausrichtung von lonenstrahl, Detektoren und Probe im Rahmen der Ortsauflösung der Messung zu erhalten.

Zudem kann einer Vibrationsentkopplung durch elastische Vakuumbauteile und Lagerungen erzielt werden, wobei der Einfluss dieser Komponenten auf die Vakuumeigenschaften zu berücksichtigen ist. Vorteilhaft können herkömmliche magnetisch gelagerte Turbomolekularpumpen eingesetzt werden. Vorteilhaft ist auch der Einsatz von 3-phasig motorisierten Vorpumpen.

Die Vakuum-Messkammer weist zudem eine Schleuse zur Aufnahme eines Probentransfersystems auf. Diese kann beispielsweise ein Fensterflansch oder eine Vakuumtransferschleuse mit einer mechanischen Durchführung sein.

Erfindungsgemäß kann neben den bislang bekannten Probenhaltern für eine oder mehrere Proben auch eine besonders adaptierte Form eines Probentransfersystems eingesetzt werden. Dieses umfasst zunächst einen Probenhalter, der werkzeuglos direkt auf wenigstens einem Probenmanipulator montiert werden kann.

In einer besonderen Ausführungsform der Erfindung vermag die Vakuum-Messkammer durch ein geeignetes Mittel zur Aufnahme eines Probentransfersystems beispielsweise verschiedene Typen von Probenmanipulatoren z. B. mit unterschiedlichen Achsen zu unterstützen, wobei diese alle denselben oder auch unterschiedliche Probenhalter verwenden können.

Durch das werkzeuglose und damit schnellere Montieren des Probenhalters kann insbesondere Zeit für das Wechseln einer Probenhalterung eingespart werden.

Erfindungsgemäß kann der werkzeugfreie Wechsel des Probenhalters sowohl im Vakuum oder auch an Luft durch einen Fensterflansch erfolgen.

Insbesondere für einen Wechsel beziehungsweise die Montage im Vakuum, bietet die erfindungsgemäße Vorrichtung besondere Vorteile, da hier ein Probenwechsel ohne Belüftung und Abpumpen der Messkammer durchgeführt werden kann.

Insbesondere kann ein Probenhalter auf einem bereits vorhandenen Probenmanipulator gegen einen neuen Probenhalter gewechselt werden. Denkbar und erfindungsgemäß kann aber auch das gesamte Probentransfersystem mit einem Probenhalter und ggfs. einem Probenmanipulator, für einen Probenwechsel jeweils aus und in die Messkammer geschleust werden. Letzteres ist beispielsweise bei stark unterschiedlich schwere Proben vorteilhaft, bei denen jeweils verschiedene Probenmanipulatoren erforderlich sind.

Der Probenhalter ist vorzugsweise für die Aufnahme mehrerer Proben geeignet (Mehrfachprobenhalter). Je mehr Proben auf einem Probenhalter angeordnet werden können, desto weniger Zeit ist anteilig für Probentransfers aus und in die Messzelle erforderlich. Dies führt ebenfalls regelmäßig zu einer Erhöhung der Messkapazität bzw. Produktivität.

Der Probenhalter ist derart ausgestaltet, dass er elektrisch isoliert von einem Probenmanipulator und der Vakuumkammer auf einem Probenmanipulator angeordnet und fixiert werden kann.

Der Probenhalter kann dadurch auf eine definierte Spannung relativ zu diesen (Probenmanipulator und der Vakuumkammer) gelegt werden, um die bei der lonenstrahlmessung auftretenden Sekundärelektronen über einen maximalen Raumwinkelbereich zu unterdrücken. Die angelegte Spannung kann für das Sekundärelektronenimaging vorzugsweise variiert werden.

Der Probenmanipulator selbst umfasst ein nicht-magnetisches Material und ist vorzugsweise als ein Mehrachsen-Probenmanipulator ausgestaltet. Die Motorisierung erfolgt vorteilhaft piezoelektrisch mit integrierten Weg-/Positionssensoren. Mit Hilfe des Probenmanipulators erfolgt die exakte Positionierung der Probe bzw. der Proben auf dem Probenhalter in Bezug auf den fokussierten lonenstrahl. Dadurch wird eine Abrasterung der Probe möglich. Unter einer Abrasterung wird dabei die laterale Vermessung der Probenoberfläche durch Verfahren der Probe und Aufnahme der Messsignale an festen Punkten (vordefiniertes Raster) oder während einer vordefinierten Bewegung (scanning) bei stets feststehendem lonenstrahl verstanden.

Durch das Verfahren des Probenmanipulators oder eines Kontaktes ist es möglich, die Probe mechanisch und/oder elektrisch im Bereich des Messflecks des lonenstrahles zu kontaktieren, um die lonenstrahlmessung mit entsprechenden Messtechniken oder Probenverändernden Techniken zu ergänzen.

Beispielsweise kann ein Draht an dem Kopplungselement angeordnet werden, mit dem eine Batterie kontaktiert werden kann und so die lonenstrahlmessung während der Lade/Entladevorgänge analysiert werden kann. Denkbar sind aber auch ein Heizelement oder ein Eindringprüfer. Diese technische Erweiterung ermöglicht es, diese Methode zu einer in-situ Analytik zu machen.

Um die korrekte Ausrichtung von Probe, lonenstrahl und Detektoren zueinander zu ermöglichen, kann die Messkammer vorzugsweise durch mehrere Stufen von feiner werdenden Justierschrauben und Laserreflektion in Translation und Rotation zum lonenstrahl ausgerichtet werden.

Die Positioniertechnik ist dabei "kalibrationsfrei", was bedeutet, dass bei einer Installation oder Variation der Messeinstellungen, z. B. der lonenstrahlenergie oder -sorte, vorteilhaft keine erneute Ortskalibration erfolgen muss, weil die Positioniertechnik die Ortsinformation bereitstellt und immer dieselbe ist.

Das Einkoppelsystem weist ein Mittel zur Aufnahme einer Probenbeobachtung auf. Dieses Mittel kann im einfachsten Fall eine ebene Fläche sein, auf der ein Beobachtungsspiegel angeordnet ist.

Das Mittel ist vorzugsweise aber auch zur Aufnahme einer komplexeren Probenbeobachtungseinrichtung geeignet. Diese umfasst wenigstens eine Kamera, die vorzugsweise über ein hochauflösendes, telezentrisches Objektiv verfügt, und über wenigstens einen Umlenkspiegel, über den die Probe aus Sicht des lonenstrahls betrachtet werden kann. Dies ist besonders vorteilhaft für den Fall, dass die Messkammer verschiedene Typen von Probenmanipulatoren z. B. mit unterschiedlichen Achsen unterstützt, die aber alle denselben Probenhalter verwenden.

Die nach dem Stand der Technik möglichen optischen Auflösungen im Mikrometerbereich ermöglichen eine schnelle Positionierung der Probe zum lonenstrahl. Die telezentrische Beobachtung ermöglicht dem Anwender eine akkurate Definition von Messrastern unabhängig von Probengeometrie und Ausrichtung bzw. Messwinkel. Zur Korrektur des Probe-zu-Detektor-Abstandes, insbesondere bei unterschiedlichen Probendicken, kann die Tiefenschärfe der Kamerabeobachtung oder ein anderes optisches oder mechanisches Abstandsmessverfahren eingesetzt werden.

Die Vakuum-Messkammer kann insbesondere zusammen mit einer lonenstrahlquelle mit einer ionenoptischen Fokussierung eingesetzt werden. Als lonenstrahlquelle kommen herkömmliche lonenstrahlquellen und Beschleuniger in Frage, bei denen typischerweise Protonen, Deuteronen oder Heliumionen mit einer Energie im Bereich von 100 keV bis zu mehreren 10 MeV eingesetzt werden. Die Ionen werden vom Beschleuniger über das lonenstrahlrohr im Vakuum bis in die Messkammer transportiert.

Die für die lonenstrahl-Mikrotomographie im Sinne der Erfindung notwendige Fokussierung des lonenstrahls kann beispielsweise über Quadrupolmagnete erfolgen, wie sie bereits an modernen Beschleunigern eingesetzt werden. Die Ebene bzw. der Punkt, in der die Fokussierung des lonenstrahles erfolgt und damit der kleinste Strahldurchmesser vorhanden ist, wird auch lonenstrahlfokus genannt.

Das Kernstück der Erfindung ist jedoch das Einkoppelsystem. Durch dieses werden vorteilhaft die optimierten verkürzten Abstände zwischen der lonenfokuslinse der Probe (lonenstrahlfokusebene) und wenigstens einem Detektor ermöglicht, die dann in Folge zu einer deutlichen Verbesserung der Messergebnisse beziehungsweise der Ortsauflösung führen.

Das erfindungsgemäße Einkoppelsystem umfasst eine lonenstrahlvakuumrohrdurchführung die gleichzeitig auch wenigstens ein Mittel zur Aufnahme für einen Detektor, ein Mittel zur Aufnahme einer Probenbeobachtung sowie ein Mittel zur Aufnahme eines Probentransfersystems aufweist.

Das Einkoppelsystem ist erfindungsgemäß kompakt ausgestaltet, vorzugsweise sogar einteilig. Sie besteht vorzugsweise aus nicht-magnetischem Edelstahl.

Das Einkoppelsystem liegt in Form einer Gelenk-Vakuumdurchführung vor.

Das Einkoppelsystem kann in einer besonderen Ausführungsform ein zweistufiges Gelenk mit lateraler und transversaler Flexibilität aufweisen.

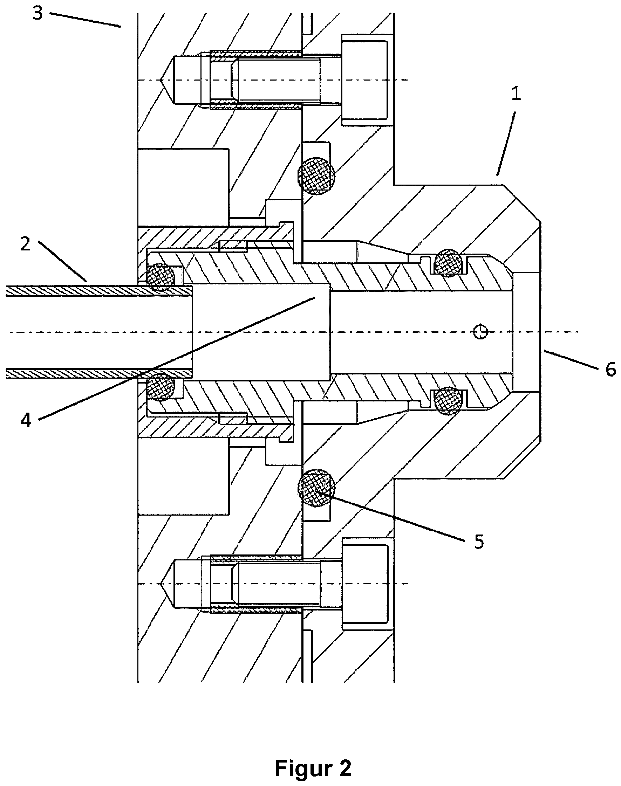

Figur 2 zeigt einen Ausschnitt einer besonders vorteilhafte Ausführungsform des Einkoppelsystems (hier ohne das Mittel zur Aufnahme für einen Detektor, ohne das Mittel zur Aufnahme einer Probenbeobachtung und ohne das Mittel zur Aufnahme eines Probentransfersystems dargestellt), der insbesondere den Bereich der lonenstrahlvakuumrohrdurchführung betrifft.

Das Einkoppelsystem weist ein Mittel zur Aufnahme eines Detektors auf. Der wenigstens eine Detektor ist dazu geeignet, wenigstens eine Teilchenart, z. B. Photonen oder Ionen zu detektieren. Vorteilhaft kann auch ein Detektor eingesetzt werden, der mehrere Teilchenarten zu detektieren vermag. Vorteilhaft kann wenigstens ein Detektor eine Blende aufweisen, die bestimmte Teilchensorten, -energien oder Streuwinkel ausblendet.

Weiterhin vorteilhaft können auch mehrere Detektoren für eine oder mehrere Teilchenarten in dem Einkoppelsystem angeordnet sein. Weitere Detektoren können auch unabhängig von dem Einkoppelsystem an dem Messaufbau vorhanden sein.

Neben dem wenigstens einen Detektor ist eine Probenbeobachtungseinrichtung, beispielsweise in Form eines (Umlenk-)Spiegels und einer Kamera mit einem hochauflösenden, telezentrischen Objektiv, an dem Einkoppelsystems angeordnet.

Optional kann auch eine lonenstrahlblende an dem Einkoppelsystem befestigt sein.

Durch die Verwendung des erfindungsgemäßen Einkoppelsystems können separate Detektorhalter, Vakuumbauteile und sonstige Befestigungen eingespart werden. Damit sinkt die Zahl der zwischen Detektor, Probe und lonenfokuslinse liegenden Bauteile und deren Dimension, womit die Abstände reduziert werden können. Die akkurate relative Ausrichtung dieser drei zentralen Elemente, und damit die Messgenauigkeit, wird mit geringeren Abständen technisch schwieriger, ein integrierter bzw. einteiliger Aufbau verlagert diese technische Herausforderung von der Montage auf die Fertigung, womit deutlich geringere Toleranzen erreicht werden können.

Vorteilhaft weist die Vorrichtung bzw. das Einkoppelsystem ein Mittel zur Korrektur des Probenoberfläche-zu-Detektor-Abstandes im eingebauten Zustand auf, um beispielsweise bei verschieden dicken oder gewölbten Proben einen konstanten Abstand zwischen Messpunkt und Detektor zu gewährleisten. Ein solches Mittel bezieht diesen variablen Abstand auf einen anderen, mit dem Detektor in fester Beziehung stehenden Abstand. Es könnte dabei vorteilhaft die Tiefenschärfe der Beobachtungskamera oder auch ein anderes optisches oder mechanisches Verfahren angewandt werden.

Die gesamte Vorrichtung liefert in einer ihrer vorteilhaften Ausführungsform die Lösung für die technischen Problemstellungen bezüglich der Vibrationen, des Probenscans, des Pumpens, der Probenbeobachtung und des magnetischen Streufeldes im Hinblick auf die Anforderungen der Detektoren und der präzisen Ausrichtung, die regelmäßig eine instrumentelle Herausforderung dieser Messtechnik darstellt. Besonderes Augenmerk wurde dabei auf die Erhöhung des Probendurchsatzes, der Messgeschwindigkeit und die Reduktion des Messvorbereitungsaufwandes gelegt.

Zusammenfassend lassen sich die Vorteile der erfindungsgemäßen Vorrichtung für die erfindungsgemäße MeV-lonenstrahl-Mikrotomographie wie folgt zusammenfassen:
- Justierbarkeit von Detektor, Probe und lonenfokuslinse auf < 0,1 mm und eine Ausrichtbarkeit auf < 0,5° durch mehrstufige Justierschrauben und erfindungsgemäßes spezielles Einkoppelsystem, erhöhter Probendurchsatz durch Einsatz eines kalibrationsfreien in-vakuum Probenmanipulators mit Schnellwechselvorrichtung, hochaufgelöste telezentrische Kamerabeobachtung und hohe Vakuum-Saugleistung bei gleichzeitig geringer Vibrationseinkopplung in die Messkammer,
- Nanometer Positioniergenauigkeit und -reproduzierbarkeit durch in-vakuum Piezo-Probenmanipulator (als Alternative zur Beam scanning-Technik), Auswahl und Anordnung der Materialien und Komponenten zur Kompensation der Wärmeausdehnung bei langen Messzeiten, Reduktion der Probenvibrationen,
- vernachlässigbare Streumagnetfelder durch Materialwahl an Kammer und Probenmanipulator, Messgerätewahl und Optimierung der Abstände Geräte zu Probe,
- sub-% Messgenauigkeit und ppm Nachweisgrenzen durch Optimierung von Detektor zu Proben Abstand für optimale Zählraten bei gleichzeitig hoher Energieauflösung (Kreissegment-Detektorblenden), Kombination dreier Messtechniken (NRA, RBS, PIXE) auf engem Raum, Sekundärelektronenunterdrückung mit voller Raumabdeckung für akkurate lonenstrommessung,
- Erhöhung der magnetischen Fokussierung für Ortsauflösungen im µm Bereich durch verringerten Abstand zwischen Magneten und Probe mittels des erfindungsgemäßen Einkoppelsystems mit z. B. integrierten Detektorhaltern, in-vakuum Probenmanipulator (statt Beam scanning) und externer telezentrischer Kamerabeobachtung über einen Umlenkspiegel,
- in-vakuum Kontaktierung von Proben, telezentrischer Beobachtung und Probenmanipulator zur in-situ Messung aktiver Prozesse,
- Optimierung des Parameterraumes minimaler Detektor-Magnet-Probe Abstand (kleiner lonenstrahldurchmesser), kleine relative Toleranzen (Genauigkeit) und Platz für Detektoren und elektrische Kontaktierung.

### Spezieller Beschreibungsteil

Im Weiteren wird die Erfindung anhand eines konkreten Ausführungsbeispiels einer erfindungsgemäßen MeV-basierten lonenstrahl-Analytikanlage näher erläutert, ohne dass dies zu einer Einschränkung des breiten Schutzumfanges führen soll. Die nachfolgend beschriebenen optimierten Einzelteile der Anlage können erfindungsgemäß einzeln oder auch in beliebiger Kombination mit dem erfindungsgemäßen Einkoppelsystem eingesetzt werden.

Im Rahmen der Erfindung wurde ein neuer Aufbau für die MeV-lonen basierte lonenstrahlAnalytik mit Ortsauflösungen zwischen 10 und 1000 nm entwickelt und vorgestellt. Das Setup kombiniert modernste Industrieprodukte zu einem zuverlässigen Gerät mit einfacher Handhabung, hoher Präzision und einem Durchsatz von > 40 Proben pro Tag. Der Aufbau besteht aus vier unabhängigen Teilen, dem Vakuumsystem, der magnetischen Fokussierung des lonenstrahls, der Probenbeobachtung und -positionierung sowie den Detektoren für die lonenstrahlanalyse. Besonderes Augenmerk wurde auf die Aufrechterhaltung eines Vakuums von etwa 10⁻⁷ mbar gelegt, ohne dass Streufelder oder signifikante Vibrationen in die Probenkammer eindringen.

In der Probenkammer erwies sich eine Kombination aus einer festen Strahlachse mit einem piezoelektrischen Präzisions-Probenmanipulator mit einer Präzision im Bereich von wenigen Nanometern und einer hochauflösenden telezentrischen Kamera als zuverlässig und praktisch für die Probenpositionierung. Drei Detektoren für geladene Teilchen und Röntgenstrahlen wurden mit speziellen Aperturen und Stoppfolien installiert, um eine Total-IBA-Analyse mit hoher Tiefenauflösung, einer Genauigkeit im sub-%-Bereich und einer Nachweisgrenze im ppm-Bereich zu ermöglichen.

Die Installation und Justierung des Geräts war eine besondere Herausforderung, da für die Ausrichtung der verschiedenen Teile eine Genauigkeit von < 0,1 mm und < 0,5° erforderlich ist um die angestrebte Messgenauigkeit von < 1 % zu erreichen. Mehrere Stufen mit Ebenen, Nivellierkameras, Lasern und Justierschrauben mit zwei Genauigkeitsstufen an mehreren dung eines Testmusters auf Szintillationsglas ermöglichte die Bestimmung der Strahlposition und des Durchmessers.

Zudem werden einige Figuren bereitgestellt, die die erfindungsgemäße Vorrichtung weiter verdeutlichen. Es zeigen:
- Figur 1:: Schematische Darstellung einer Ausführungsform des erfindungsgemäßen Einkoppelsystems, umfassend eine lonenstrahlvakuumdurchführung, ein Mittel zur Aufnahme einer Probenbeobachtung, z.B. ein Spiegel, ein Mittel zur Aufnahme eines Detektors sowie ein Mittel zur Aufnahme eines Probentransfersystems (hier eine Montageschiene).
- Figur 2:: Ausschnitt eines vorteilhaften Ausführungsbeispiels des Einkoppelsystems. Links schließt die lonenfokuslinse, rechts der Probenhalter an. Das Ausführungsbeispiel verwendet ein doppeltes Gelenk mit O-Ring Dichtungen zur mechanischen Entkopplung. 1= Einkoppelsystem, 2 = lonenstrahlrohr, 3 = Vakuummesskammer, 4 = 2-Achsen Vakuum-Gelenk, 5 = O-Ring Dichtung, 6 = Innenseite der Messkammer.

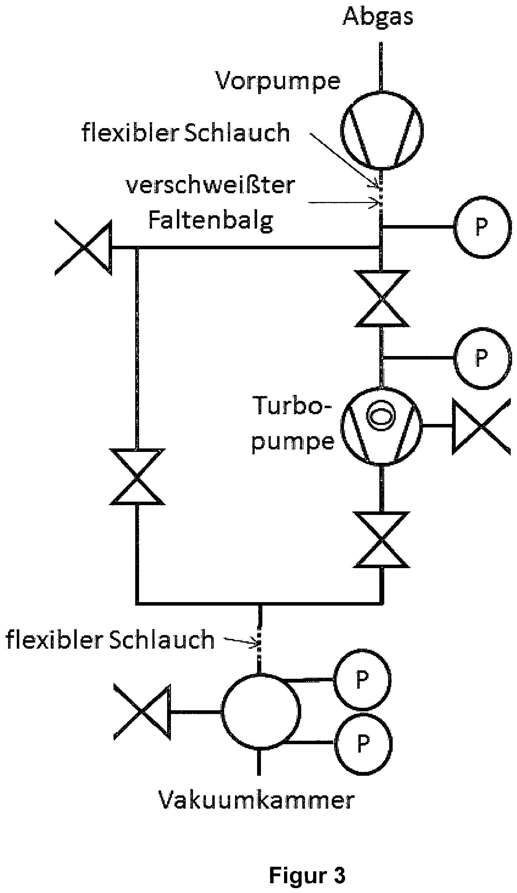

- Figur 3:: Schematische Darstellung eines vorteilhaften Pumpsystems. Das benötigte Pumpsystem muss ein schnelles Abpumpen und ein möglichst vibrationsfreies Arbeiten ermöglichen. Dazu ist ein Bypass vorgesehen, sodass eine Turbopumpe durchgehend weiterlaufen kann. Die Verwendung von Vakuumkomponenten mit geringer Steifigkeit verringert ebenfalls vorzugsweise eine Übertragung von Vibrationen. Für ein schnelles Abpumpen wird der Bypass zu einer Drehschieberpumpe genutzt, um Drücke von weniger als 0,1 mbar zu erreichen. Anschließend kann der Bypass geschlossen werden, um ein Vakuum von bis zu 5 * 10⁻³ mbar zu erreichen.
- Figur 4:: a) 1" x 3" Positiv, USAF 1951 Wheel Target mit Chromlinien auf szintillierendem Floatglas. Jeder Block enthält eine Reihe von Dreifachlinien mit abnehmender Größe. Die Linienabstände und die Linienbreite jedes Tripletts sind bekannt, daher liefert das kleinste auflösbare Linientriplett die Auflösung der Kamera oder des lonenstrahls.
b) Vergrößerung von a).
c) Vergrößerung von b). Das Bild zeigt ein Linienpaar mit einer Entfernung von Mitte zu Mitte von 22 Pixeln. Gemäß den Spezifikationen gibt es acht Paare von Linien pro mm auf diesem Triplett. Daher hat ein Linienpaar einen Abstand von 0,125 mm und die Pixel sind auf eine räumliche Breite von 5,68 µm kalibriert.
- Figur 5:: a) Detail des USAF 1951 Testmusters mit f / 6 Blende. Im besten Fall können die Linien des fünften Elements der Fünftelgruppe (Box) getrennt werden, was eine räumliche Auflösung von 19,7 µm ergibt.
- Figur 6:: b) Auflösung in Bezug auf Blende und Arbeitsabstand. Schematische Darstellung einer Ausführungsform einer erfindungsgemäßen MeV-Analytikanlage mit Einkoppelsystem. Links: Das µNRA-Setup zusammen mit den Fokussiermagneten auf dem schwingungsdämpfenden Tisch.
Rechts: Schnitt der Vakuumkammer mit Einkloppelsystem mit daran angeordnetem Probenmanipulator mit Probe, Probenbeobachtung und Detektor.
- Figur 7:: Skizze des fokussierenden Setups. Der lonenstrahl kommt von der rechten Seite. Die Objekt/Blendenöffnung definiert ihre Größe.
Drei Quadrupol-Magnete fokussieren den Strahl auf die bewegliche Probe.

Der technische Aufbau der erfindungsgemäßen Ausführungsform der Erfindung kombiniert einen Dreifach-Quadrupol-Fokussiermagneten, eine UHV-Messkammer, einen schwingungsisolierten Tisch und den Detektoraufbau. Die Magnete induzieren entlang der optischen Achse eine Feldstärke von bis zu 0,4 T. Sie können mit einer Genauigkeit von 1 µm ausgerichtet werden. Der Strahlstrom wird von dem Hersteller der Magnete für eine Punktgröße von 1 µm bei einem Abstand von 160 mm zwischen letztem Magneten und der Probe auf 0,6 nA spezifiziert. Für gute Detektionsgrenzen von Leichtelementen bei einer Tiefenauflösung von ca. 100 nm definieren einige 100 pA eine praktische Grenze. Daher kann der Ionenstrahlteil die erforderlichen Strahleigenschaften liefern.

Die Konstruktion eines technischen Aufbaus in diesem Präzisionsbereich in Kombination mit der Möglichkeit eines häufigen Probenaustausches sowie die Anforderungen an eine präzise Winkelausrichtung und geringe ionenspezifische Dosen, so wie sie erfindungsgemäß vorgeschlagen wird, erforderten die Entwicklung eines neuen Analyse-Setups für eine MeVlonenanalytikanlage, welches im Rahmen der Erfindung unter der Bezeichnung µNRA nachfolgend beschrieben wird.

Die einzelnen Komponenten dieses technischen Aufbaus einer vorteilhaften Ausführungsform der Erfindung werden näher beschrieben. Dazu gehören:
a. Pumpsystem und Vibrationsdämpfung
b. Probenbeobachtung
c. Vakuum-Messkammer und Strahllinie
d. Magnetisches Fokussiersystem
e. Positionierung der Proben bzw. des Probenmanipulators
f. Detektorsystem für die lonenstrahlanalyse

### a. Pumpsystem und Vibrationsdämpfung

Das Pumpsystem der Vakuumkammer ist so konstruiert, dass es einen niedrigen Basisdruck von 5 ± 2 * 10⁻⁸ mbar für stabile Probenoberflächen und lonenenergieverluste << 0,1 keV liefert. Gleichzeitig ermöglicht es einen schnellen Probenaustausch und schnelles Abpumpen. Außerdem sollte das Pumpsystem keine magnetischen Streufelder und Vibrationen in die Messkammer induzieren. Dazu umfasst das erfindungsgemäße Pumpsystem drei Teile, die durch Schieber und elastische Elemente unterteilt sind, wie in Figur 2 gezeigt.

Zu diesen drei Teilen gehören eine Vorvakuumpumpe, eine Turbopumpe und ein µNRA-Kammerteil (= Vakuum-Messkammer). Jedes dieser drei Teile ist mit einem Vakuummeter und einem Entlüftungsventil für einen sicheren Zugang und einfache Wartung ausgestattet. Das Pumpsystem ist an einem seitlichen CF100-Port der Probenkammer installiert.

Die Drehschieber-Vorpumpe ist primär für die Schwingung des Pumpsystems verantwortlich. Die Turbomolekularpumpe (Pfeiffer 300M) arbeitet mit vollständig berührungslos arbeitenden Magnetlagern, wodurch die externe Schwingungsamplitude stark gemindert wird. Starre Vakuumleitungen führen in der Regel dazu, dass diese Vibrationen auf die Proben in der Analysekammer übertragen werden. Um diese Übertragung zu reduzieren, werden erfindungsgemäß Vakuumkomponenten mit geringer Steifigkeit installiert, um die Schwingungsamplitude unter 1 µm zu reduzieren.

Um den Erfolg dieses Ansatzes zu quantifizieren, wird die Schwingungsamplitude mit einem hochgenauen LK-H052 Laserdistanzmessgerät von KEYENCE gemessen. Der Wegsensor arbeitet mit einer Wiederholgenauigkeit von 0,025 µm, einem Spotdurchmesser von 50 µm und einer Messfrequenz von 50 kHz (maximal erfassbare Vibrationsfrequenz von 25 kHz). Der Laser befindet sich auf einem Stativ neben dem vibrationsarmen Tisch. Wenn der Laser auf den verschiedenen Punkten positioniert ist, wird die Entfernung für 60 s in 3 Millionen Punkten aufgezeichnet. An verschiedenen Stellen des Vakuumsystems konnten Amplituden bis zu 1,6 µm nachgewiesen werden, während die Vibrationen an der Probenposition unterhalb der Nachweisgrenze lagen.

### b. Probenbeobachtung

Für die Probenbeobachtung wurde eine Farbkamera FLEA3-FL3-U3-88S2C mit einem 8,8-MPixel-1 / 2,5-Zoll-Detektor mit einer 0,28-fach telezentrischen Linse von Techspec und mit einem Arbeitsabstand von 180 mm kombiniert. Dies bietet ein Sichtfeld von ca. 23 mm (1/2"-Kamera), eine Schärfentiefe von ± 7 mm und eine Telezentrizität von < 0,03°. Aufgrund der Telezentrizität werden die Proben immer virtuell frontal beobachtet, sodass alle Abstände über das gesamte Sichtfeld erhalten bleiben, auch wenn die Proben gedreht werden. Dies ermöglicht das Auffinden der Strahlposition und -größe auf einem Szintillator, das Speichern dieser Position auf dem Kamerabild und das Navigieren auf nicht szintillierenden Proben mit genauer Kenntnis der zurückgelegten Entfernungen.

Nach jedem Probenwechsel ist eine Positionsverifikation mit dem Kamerasystem erforderlich, da mechanische Toleranzen und Änderungen der Strahloptik die Genauigkeit der Positionierung von Proben und lonenstrahl begrenzen. Ein Fernfeldmikroskop hätte zwar eine bessere räumliche Auflösung bieten können als die telezentrische Linse, aber die erfindungsgemäß gewählte Lösung bietet das größere Sichtfeld, eine höhere Tiefenschärfe, Telezentrizität und auch deutlich niedrigere Kosten. Die Kamera wird zuerst außerhalb getestet und später auf der Vakuum-Messkammer installiert. Bei der Installation ermöglichen die Einstellschrauben Neigungs-, Dreh- und Entfernungseinstellungen durch Beobachtung von Proben am eingestellten Probenmanipulator.

Der telezentrische Kameraaufbau wird zuerst in einem Prüfstand mit Hilfe eines standardisierten vakuumkompatiblen Testmusters kalibriert, das auch für die späteren Strahlauflösungstests verwendet wird. Die beste räumliche Auflösung wird durch Verifizieren der folgenden Parameter gefunden: Einfallswinkel, Objektivblende, die Testmusterposition im Sichtfeld der Kamera, die Testmusterbeleuchtung und der Abstand zwischen Objektivfront und Testmuster. Der Abstand zwischen zwei Linienzentren auf dem Testmuster verglichen mit der Anzahl von Pixeln zwischen zwei Linien ergibt dabei die Pixelbreitenkalibrierung, wie in Figur 3 dargestellt. Im Durchschnitt entspricht ein Pixel 5,71 ± 0,12 µm, verglichen mit nominal 5,5 µm / Pixel. Eine Änderung der Position des Testmusters im Sichtfeld der Kamera hat keinen Einfluss auf diese Kalibrierung und bestätigt somit die Telezentrizität des Objektivs.

Die Ortsauflösung wird hinsichtlich des Einfallswinkels, der Blendenöffnung, der Testbildlage im Kamerasichtfeld, der Testbildbeleuchtung und der Entfernung zwischen Kamerafront und Testbild (Arbeitsabstand) überprüft. Ähnlich wie bei der räumlichen Kalibrierung wird neben der Beeinflussung des Arbeitsabstandes über das Sehfeld bei nicht-senkrechter Beobachtung auch kein Einfluss des Beobachtungswinkels auf die Ortsauflösung beobachtet. Der Arbeitsabstand wird zur senkrechten Beobachtung zwischen 177 mm und 185 mm variiert, mit einem nominalen Arbeitsabstand von 180 mm.

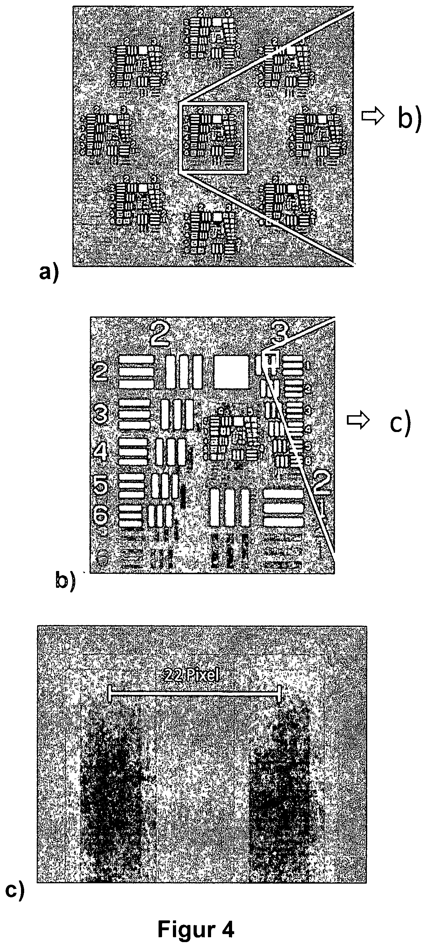

Die räumliche Auflösung wird ermittelt, indem überprüft wird, welche Elemente des Testbildes die Kamera noch mit dem Auge trennbar sind. Die beste räumliche Auflösung wird bei voller Öffnung mit einem Maximum von 19,7 + 0 - 2,1 µm bei 180 mm Abstand zwischen Kameralinsenfront und Testmuster erreicht. Nur eine vernachlässigbare Verschlechterung der Auflösung tritt zwischen 180 und 183 mm auf (siehe Figur 4).

Die Aussage des Herstellers von einer räumlichen Auflösung von 10 µm bei reduzierter Aperturöffnung wird nicht erreicht, wahrscheinlich weil die Beleuchtung bei geschlossener Apertur nicht ausreichend war und Kamerarauschen bei schlechten Lichtverhältnissen dominiert. Leider verhindert die Anwendung in einer lonenstrahlanalysekammer eine intensivere Beleuchtung aufgrund einer möglichen Beschädigung der lichtempfindlichen Strahlungsdetektoren.

### c. Vakuum-Messkammer und Strahllinie

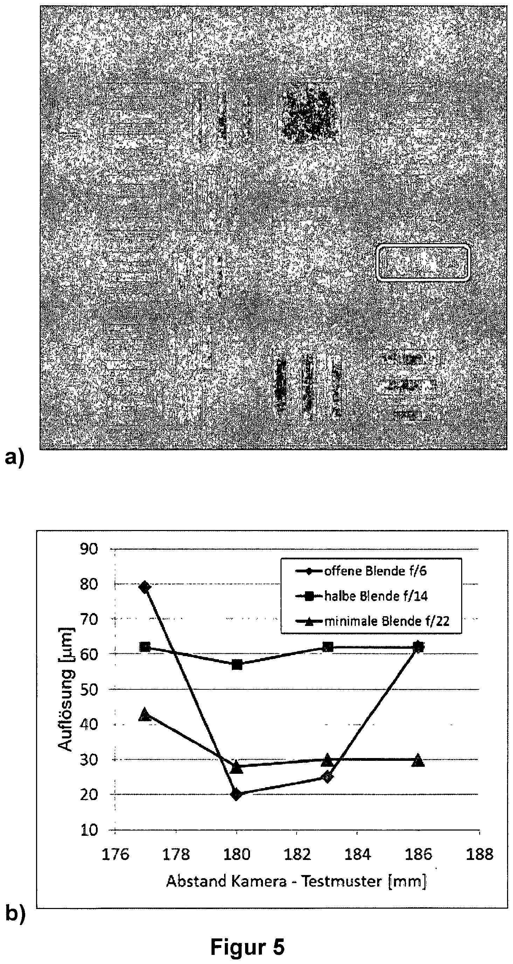

Die Figur 5 zeigt eine in CATIA konstruierte sehr vorteilhafte Ausführungsform der Erfindung mit einer optimierten Vakuum-Messkammer und dem Strahlrohr als Teil der Strahllinie. Die Herstellung erfolgt mit engen Toleranzen an den Punkten, an denen ein Einfluss auf Messwinkel und -entfernungen relevant ist, z. B bei dem lonenstrahlauftreffwinkel.

Die Strahlführung besteht aus CF100 316 Edelstahl-Vakuumteilen und hat eine Länge von Probe zu Schaltmagnet von ca. 5 m. Sie ist mit der gleichen Vor- und Turbopumpe wie die Vakuum-Messkammer ausgestattet und erreicht einen Basisdruck von 1 * 10⁻⁸ mbar.

Zwei Faradaybecher und ein Strahlprofilmonitor sind für die Strahldiagnose installiert. Ein Steuermagnet nach der ersten Öffnung bietet zusätzliche Flexibilität für die Strahlsteuerung.

Die Vakuum-Messkammer ist aus Edelstahl 316 gefertigt und von innen und außen mechanisch poliert. Sie verfügt über 18 CF-Flansche für Durchführungen, über wenigstens einen Detektor, über eine Probenbeobachtung und einen Probenzugang sowie das individuell gestaltete kurze kompakte Einkoppelsystem für die flexible Verbindung des Strahlrohrs mit der Vakuum-Messkammer.

Bei der Montage von Strahlrohr und Vakuum-Messkammer wird besonderes Augenmerk auf die Vermeidung von Streufeldern in der Strahllinie und im Detektorbereich gelegt. Magnetfeldmessungen zeigten die Vakuummeter (Pfeiffer Vacuum PKR 360), die (elektropneumatischen) Ventilstellantriebe und die magnetisch gelagerten Turbomolekularpumpen als kritische Quellen für unerwünschte Felder.

Um den Streufeldeinfluss auf den lonenstrahl und die Kernreaktionsprodukte abzuschwächen, sind diese Vorrichtungen auf Verlängerungsflanschen angebracht, die einen ausreichenden Abstand vorsehen, um unter 10 µT jeweils in der Strahlmittellinie und in der Messkammer zu erhalten. Die Felder werden mit einem Hand-Magnetkompass mit einer effektiven Auflösung von 1 µT (digitale Auflösung 0,01 µT) gemessen. Das Streufeld konnte in einem Abstand von 450 mm für die Turbomolekularpumpe bzw. von 200 mm für die Vakuummeter und -aktoren nicht mehr nachgewiesen werden.

Die Strahllinie wird mit Hilfe einer Nivellierungskamera montiert und ausgerichtet. Alle Flansche sind um ± 1 mm um die ideale Achse zentriert, einschließlich der Strahllinie, Magneten, Öffnungen und der Probenkammer auf dem Tisch (siehe auch Figur 5).

Nach dem Zentrieren wird die Vakuum-Messkammer mit Hilfe von Einstellschrauben und einem Laserstrahl, der 5 m entfernt auf der Rückseite des Verteilmagneten eingestrahlt wird, mit einer Genauigkeit von 10⁻⁴ ° gegen die Strahlachse ausgerichtet. Nach der Strahlrohrund Vakuum-Messkammermontage wird der Probenmanipulator in die Messkammer eingebaut. Die erreichte Präzision bei der Montage ermöglicht in der nächsten Stufe die Feinjustierung aller Teile mit ihren individuellen Feinjustierschrauben.

Thermische Drifts, die für relative Strahlfleckbewegungen relevant sind, werden durch Umgebungsmessungen über eine Woche im Sommer bewertet. Raumtemperaturschwankungen wurden in der Größenordnung von bis zu 1 K / h festgestellt. Die steilste Steigung wurde typischerweise um 10:00 bis 12:00 Uhr beobachtet. Die Gesamttemperaturschwankungen zwischen 8:00 und 20:00 Uhr blieben innerhalb von 2 K. Die maximal angenommene Temperaturdifferenz beträgt 1 K, da alle Metallkomponenten eine angemessene Wärmeleitfähigkeit für die Äquilibrierung bereitstellen. Die Messung ergab auch Veränderungen der relativen Feuchtigkeit im Bereich von 30 - 70%. Um feuchtigkeitsbedingte Quellung zu vermeiden, wurden ausschließlich Metalle für die gesamte Stützstruktur verwendet.

Für Langzeit-Ionenstrahlmessungen wird eine Positionsveränderung zwischen der letzten Blende und der Probe (die beide auf demselben vibrationsarmen Tisch angeordnet sind) als die relevante Größe angesehen. Abstandsänderungen sind nicht relevant, da sie im Vergleich zu der Fokuslänge, die im nächsten Abschnitt diskutiert wird, vernachlässigbar sein werden.

Das Hauptproblem sind vertikale Verschiebungen, die durch thermische Ausdehnung der Tragstrukturen induziert werden. Die Blende befindet sich auf einer Aluminiumschiene, während die Probe in einer Vakuum-Messkammer aus Edelstahl auf einem Probenmanipulator umfassend eine Kobalt-Chrom-Nickel-Legierung (Phynox) angeordnet ist. Unter der Annahme, dass der vibrationsarme Tisch für alle auf ihm montierten Teile dieselbe Verschiebung hervorruft, ist nur die Höhe der Strahllinie oberhalb des Tisches relevant, die 150 mm beträgt. Berücksichtigt man den thermischen Ausdehnungskoeffizienten von Aluminium mit 2,3 * 10⁻⁵ K⁻¹ verringert um den thermischen Ausdehnungskoeffizienten von Edelstahl mit 1,0 * 10⁻⁵ K⁻¹ würde sich eine maximale Verschiebung von 2 µm in der Höhe als obere Grenze bei einer Temperaturdifferenz von 1 K berechnen lassen. In einem realistischen Fall mit Temperaturleitung wird der Wärmeausdehnungseffekt als vernachlässigbar angenommen, sofern nicht wesentlich kleinere Strahlflecke realisiert werden.

### d. Magnetisches Fokussiersystem

Für eine hochauflösende lonenstrahlanalyse wird ein mikro-Strahl benötigt, der einen maximalen lonenstrom in einem minimalen Strahldurchmesser bereitstellt. Zu diesem Zweck sind Strahlfokussierung und Strahlblenden erforderlich. Im vorliegenden Ausführungsbeispiel der Erfindung wird ein Triple-Quadrupol-Magnet bestehend aus drei Oxford Microbeams OM-56 mit 10 mm Bohrung im Abstand von 123 mm zwischen dem letzten Magneteisenkern und der Probe installiert.

Für spezielle Anwendungen kann durch Verschieben des Probenhalters ein Mindestabstand von 100 mm realisiert werden, jedoch ist dann eine Nachjustierung der Detektoren erforderlich.

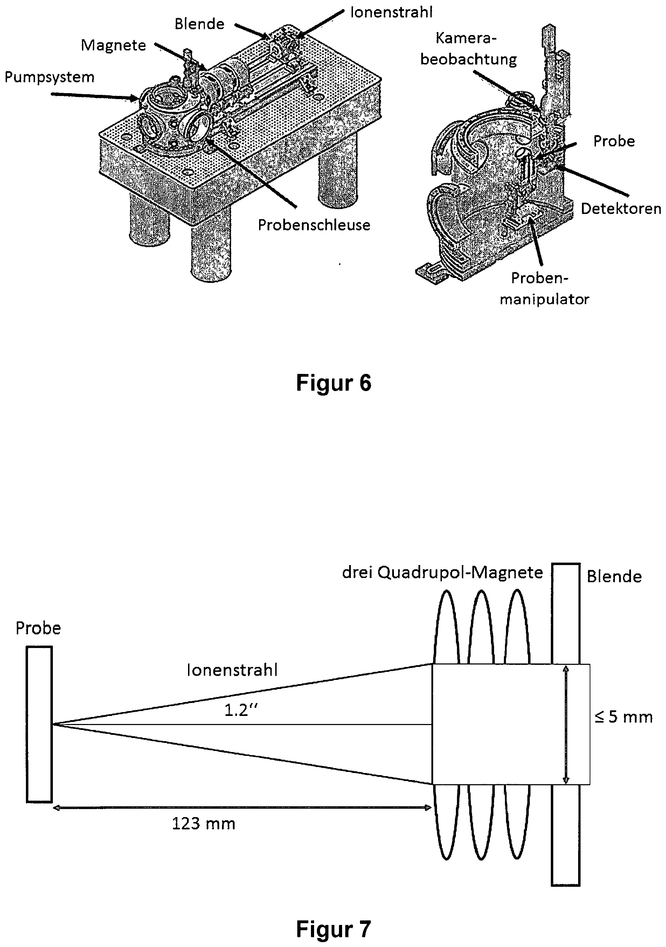

Da der Mikrofokus mit einem konvergenten Strahl arbeitet, ist eine Auftreffwinkelverteilung von bis zu 1,2° mit einer maximalen spezifizierten Verkleinerung von etwa 100 für einen Linienfokus und etwa 25 für einen Punktfokus vorhanden, siehe dazu Figur 6. Dies kann Unterschiede in der Sondierungstiefe und Energieverlust der Projektile in der Probe induzieren, aber mit typischen Werten von ≤ 0,3° ist dies regelmäßig vernachlässigbar im Vergleich zu der geometrischen Streuung, die durch endliche Detektorabmessungen hervorgerufen wird.

Die Magnete werden durch zwei hochstabile Netzteile mit bis zu 3 V und 100 A mit < 10 mA Restwelligkeit und < 5 ppm/K Drifts betrieben. Durch den Anschluss der Netzteile in unterschiedlicher Polarität und Gruppierung können vertikale oder horizontale Linien oder runde lonenstrahlflecke erzeugt werden.

Im Allgemeinen ist zu berücksichtigen, dass aufgrund der Axiallänge jedes Magneten von 100 mm die maximale Verkleinerung der Probe bei ganz unterschiedlichen Anregungen an jedem Magneten erreicht wird. Um dies zu kompensieren, wird der Zentralmagnet mit entgegengesetzter Polarität zu den beiden äußeren Magneten angeschlossen und der Endmagnet wird einzeln angetrieben. Die Magnete können auf der Skala von ± 1 - 2000 µm und < 5° um die Grundeinstellung ihrer Grundplatte (Aluschiene auf dem vibrationsarmen Tisch) durch Justieren von Mikrometerschrauben eingestellt werden.

Vor Inbetriebnahme werden alle Magnete auf der Strahlachse zentriert, indem jeder einzelne Magnet in beiden Polarisationen angeschlossen wird und ihre horizontale und vertikale Strahlablenkung und der rhombische Fokuseffekt mit Hilfe dieser Mikrometerschrauben auf Null reduziert werden.

Der Strahlfleck auf der Probe wird unter Verwendung der Probenbeobachtungskamera und eines szintillierenden LiAlO₂-Einkristalltargets beobachtet, welches mit einem Protonenstrahl von 3 MeV von etwa 1 nA bestrahlt wird. Die genaue Bestimmung der optimalen Magnetströme und der Fokussierung wird im nächsten Abschnitt beschrieben.

### e. Positionierung der Proben bzw. des Probenmanipulators

Ein In-Vakuum-Probenmanipulator ermöglicht die Abbildung der Proben. Der Probenmanipulator bietet Manipulationsbereiche von ± 25 mm in drei Achsen mit einer Positioniergenauigkeit von 10 nm und einer Positionsauflösung von 1 nm. Dieser Aufbau bietet mehrere Vorteile gegenüber dem lonenstrahlscannen, da eine räumliche Kalibrierung nicht erforderlich ist, der lonenstrahl immer in der idealen Strahlachse bleiben kann, ein kleinerer Magnet-Probenabstand (kein Abtastmagnet) und ein größerer Abtastbereich erreicht werden.

Andererseits ist ein komplexer Probenmanipulator mit nicht-magnetischen Materialien und Motoren und einem dynamischen Bewegungsbereich von etwa 10⁶ mit Bewegungsgeschwindigkeiten von nm/s bis cm/s erforderlich.

Die lineare Bewegung des Probenmanipulators wird durch piezoelektrische Motoren angetrieben. Ein wesentlicher Handhabungsvorteil ist die Überlastungstoleranz der Piezomotoren, die eine Beschädigung des Motors verhindert, wenn während der Montage zu viel Kraft aufgebracht wird. Der Probenmanipulator wird durch seine internen Positionssensoren kalibriert und referenziert, die durch die telezentrische Kamera verifiziert wurden.

Die Gewichtsannahme des Probenmanipulators beträgt 300 g bis 600 g (150 g Motorkraft) einschließlich des Probenhalters. Dieser Gewichtstoleranzbereich wurde für die typischen Proben ausgewählt, kann jedoch durch Ändern der entgegenwirkenden Feder (hier 450 g Gegengewicht) des Probenmanipulators auf andere Anforderungen zugeschnitten werden. Am Probenmanipulator können verschiedene Arten von Probenhaltern auf einem selbstzentrierenden Adapter installiert werden, um entweder vielen kleinen Proben oder wenigen grö-ßeren Proben zu entsprechen.

Die Dreh- und Neigungswinkel wurden durch Laserreflexion von einer hochglanzpolierten Probe, die auf dem Probenhalter montiert war, ausgerichtet. Zu diesem Zweck wird ein Laserstrahl in die Rückseite des Schaltmagneten eingeleitet. Der Laserstrahl bewegt sich durch die 5 m lange lonenstrahllinie durch eine 2 mm Blende auf die Vakuum-Messkammer und wird dann von dem Spiegel reflektiert, der auf dem Probenhalter montiert ist. Die Neigungsund Drehwinkel des Probenmanipulators werden so lange korrigiert, bis der Laser in einem Abstand von 100 mm durch das 2-mm-Eingangsloch des Lineals zurückreflektiert wird. Dies führt zu einer Winkelgenauigkeit der Ausrichtung von ± 0,2°.

Daher hat der lonenstrahl-Auftreffwinkel die gleiche Genauigkeit, aber der Detektor hat eine zusätzliche Unsicherheit, die von der relativen Ausrichtungsunsicherheit des Lineals und des Detektorhalters von ± 1 mm herrührt. Diese Toleranzen im lonenstrahl-Auftreffwinkel können zu Abweichungen der Messergebnisse in der Größenordnung von 0,1% führen.

Darüber hinaus wurde das Probenmanipulatorsystem zum direkten elektrischen Kontaktieren von Proben im Vakuum, z. B. offene Batteriezellen, genutzt. Die Installation einer Kontaktnadel vor der Probenebene ermöglicht eine direkte Beobachtung und Videoaufnahme des Kontaktpunktes und mögliche Auswirkungen auf die Probe. Das Bewegen des Probenmanipulators in Richtung der Kontaktnadel führt zu zuverlässigen Kontakten mit Kontaktwiderständen in der Größenordnung von 1 Ω. Der Kontaktdruck wurde variiert, indem die Probenmanipulatorposition auf der mm -Skala mit nur geringer Auswirkung auf den Detektorwinkel (~ 31 mm Probe-Detektor-Abstand) gesteuert wurde. Zusätzliche elektrische Kontakte der Proben sind über eine Vakuumdurchführung möglich, was eine Vielzahl von in-situ Experimenten mit hoher Flexibilität in Spannung, Strom und Frequenz ermöglicht.

Für den letzten Schritt des Aufbaus der fokussierenden Magnetströme wurden verschiedene Gruppen des USAF 1951 Testbildes mit dem Probenmanipulator angesteuert. Die Magnetströme wurden erhöht und die Größe der Strahlenfluoreszenz wurde mit der bekannten Linienbreite der Testbildgruppen verglichen. Es wurden kleinere Liniengruppen angestrebt, bis neben dem metallisierten Teil kein Licht mehr zu sehen war. Diese Prozedur wurde für horizontale und vertikale Liniengruppen wiederholt, was aufgrund der endlichen Intergruppenunterschiede zu einer Genauigkeit der Strahlgrößenbestimmung von etwa 5 % führte.

Das Verfahren ermöglicht die Bestimmung der Strahlgröße sogar für Strahlpunkte, die kleiner als die optische Auflösung der Kamera sind, und für Strahlen mit hoher Stromdichte. Die minimale Spotgröße wurde zu 50 × 35 µm² mit einer Objektapertur von 1200 × 1200 µm² bestimmt. Entsprechend wurde eine Verkleinerung von 24 bzw. 34 erreicht.

### f. Detektorsystem für die lonenstrahlanalyse

Zur Detektion von geladenen Teilchen für NRA und RBS wurden zwei Siliziumdetektoren mit einem Reaktionswinkel von 165 ° zur Trennung verschiedener Teilchenarten installiert. Lichtinduzierte Hintergrundsignale in den Detektoren werden durch eine vollständige Abdeckung aller Fenster während der Messung vermieden. Ein hochauflösender Detektor mit 11 keV FWHM bei 2 µs Anstiegszeit (oder 16 keV bei 0,6 µs), 50 mm² Größe und 100 µm nominaler aktiver Dicke detektiert Protonen bis etwa 3,5 MeV und Alphas bis etwa 15 MeV. Der zweite Detektor hat eine aktive Dicke von 1500 µm, eine Größe von 150 mm² und eine FWHM-Auflösung von 22 keV bei einer Anstiegszeit von 1,4 µs.

Dieser zweite Detektor ist mit einer Stoppfolie aus 25 µm dickem Polyimid ausgestattet, die mit 30 nm Al beschichtet ist, um einfallendes Licht und Alpha-Teilchen unter etwa 5 MeV zu blockieren. Beide Detektoren können mit Aperturen in Form eines Segments des 165°-Kreises ausgestattet werden, um Zählraten und geometrische Streuung zu begrenzen. Die Öffnung hat eine Öffnung von 4 mm oder 1,5 mm. Der verbleibende Detektorraumwinkel wurde experimentell unter Verwendung der 7Li (p, α) 4He-Reaktion auf eine Genauigkeit besser als 1 % für alle Fälle mit z. B. 3,52 ± 0,04-facher reduziertem Raumwinkel für eine 1,5 mm Apertur am hochauflösenden Detektor kalibriert.

Für die PIXE-Analyse zählt ein KETEK AXAS-D Silizium-Drift-Detektor mit 450 µm aktiver Dicke die emittierten Röntgenstrahlen. Um einfallende geladene Teilchen bis zu 4 MeV Protonen und 15 MeV Alphas zu blockieren, ist der Detektor mit einer 200 µm dicken Graphitfolie von 1,2 g / cm³ und 8 µm Beryllium ausgestattet. Der Detektor betrachtet die Proben aus einem Winkel von 45° von einem Anschluss in der Probenebene. Der Abstand zur Probe kann von 30 bis 200 mm eingestellt werden, um die Zählraten zu optimieren. Der Detektor wird durch K- und L-Linien aus hochreinen W-, Mo- und Y-Targets kalibriert. Sein H-Faktor (energieabhängige Empfindlichkeit) wird durch die gleichen Proben in Kombination mit der Normalisierung durch die jeweiligen RBS-Signale bestimmt.

Eine quantitative Analyse der Probenzusammensetzung durch lonenstrahlanalyse erfordert die Bestimmung des Particle * Sr-Wertes. Dieser Wert besteht aus dem Raumwinkel des Detektors und dem Strom und der Ladung des einfallenden Ions. Der lonenstrom wurde unter Verwendung eines Keithley 6487 Pico-Amperemeters durch Software-Logging und Integration mit einer Genauigkeit von besser als 0,1 % gemessen. Der relevante Fehler in der gesammelten Ladung entsteht durch die Emission von Sekundärelektronen durch den lonenstrahistoß. Um diese Sekundärelektronen zu unterdrücken, ist ein elektrisches Feld erforderlich, das sie zurück auf die Probe treibt.

Im vorliegenden Aufbau wurde eine Isolation des Probenhalters gegen die umgebenden Strukturen installiert. Der (metallische) Probenhalter selbst wurde unter Verwendung der Spannungsquellen des Piko-Amperemeters gegen die Erdung vorgespannt. Dieses Vorspannungsschema ermöglicht eine maximale Unterdrückung von Sekundärelektronen, da es gegen alle Richtungen wirkt. Die Unterdrückung von Sekundärelektronen für eine korrekte Messung des einfallenden lonenstroms wird unter Verwendung eines 3 MeV 4He-Strahls an einer W-Probe getestet. Der scheinbare einfallende lonenstrom wird für unterschiedliche Probenvorspannungen unter Verwendung des Piko-Amperemessers gemessen. Der gemessene Strom stabilisiert sich oberhalb von 60 V, was auf eine vollständige Unterdrückung der Sekundärelektronen hinweist, aber die Strahlstabilität reichte nicht für eine Genauigkeit von < 10 % aus.

## Patentansprüche

1. Vorrichtung für eine MeV basierte Ionenstrahl-Analytik einer Probe, umfassend
- eine Vakuum-Messkammer (3) mit wenigstens einem Detektor und einem Beobachtungsspiegel und/oder einer Kamera zur Probenbeobachtung,
- ein Vakuumsystem zur Erzeugung eines Vakuums innerhalb der VakuumMesskammer,
- ein Ionenstrahlrohr (2) sowie ein Fokussiersystem zur Fokussierung eines Ionenstrahls,
- ein Probentransfersystem, umfassend einen Probenmanipulator mit einer Probenhalterung zur Aufnahme wenigstens einer Probe,
***dadurch gekennzeichnet, dass***
die Vorrichtung ein Einkoppelsystem (1) in Form einer Gelenk-Vakuumdurchführung für den vakuumdichten Anschluss des Ionenstrahlronres (2) an die Messkammer (3) aufweist,
- welches eine lonenstrahlvakuumdurchführung, wenigstens ein Mittel zur Aufnahme des wenigstens einen Detektors, wenigstens ein Mittel zur Aufnahme des Beobachtungsspiegels und/oder der Kamera, sowie ein Mittel zur Aufnahme des Probentransfersystems umfasst, wobei der Detektor, der Beobachtungsspiegel und/oder die Kamera und das Probentransfersystem jeweils über das vorgenannte Aufnahmemittel mit dem Einkoppelsystem verbunden sind,
- und so eine mechanische Verbindung zwischen den Bauteilen lonenoptik, Detektor, Beobachtungsspiegel und/oder Kamera und Probentransfersystem darstellt, wodurch geringe Abstände und eine präzise Ausrichtung zwischen dem letzten ionenoptischen Bauteil des Fokussiersystems, der zu untersuchenden Probe und dem Detektor ermöglicht werden.

2. Vorrichtung nach vorhergehendem Anspruch 1, mit einem Einkoppelsystem (1) umfassend ein zweistufiges Gelenk mit lateraler und transversaler Flexibilität.

3. Vorrichtung nach einem der vorhergehenden Ansprüche 1 bis 2, mit einem Detektor für wenigstens zwei Teilchenarten oder Teilchenbremsvermögen.

4. Vorrichtung nach einem der vorhergehenden Ansprüche 1 bis 3, mit einem kreisförmigen Detektor mit einer Mittelbohrung.

5. Vorrichtung nach einem der vorhergehenden Ansprüche 1 bis 4,
mit einer Probenbeobachtung, die eine telezentrische Kamera sowie einen Umlenkspiegel aufweist.

6. Vorrichtung nach einem der vorhergehenden Ansprüche 1 bis 5,
mit einem Mittel zur Korrektur des Probenoberfläche-zu-Detektor-Abstandes im eingebauten Zustand.

7. Vorrichtung nach einem der vorhergehenden Ansprüche 1 bis 6,
mit einem Vakuumsystem umfassend Vakuummess- und Vakuumanalysegeräte.

8. Vorrichtung nach einem der vorhergehenden Ansprüche 1 bis 7,
mit einem nicht magnetischen Probenmanipulator.

## Claims

1. A device for a MeV based ion beam analysis of a sample, comprising
- a vacuum measurement chamber (3) with at least one detector and an observation mirror and/or a camera for sample observation,
- a vacuum system for generating a vacuum within the vacuum measurement chamber,
- an ion beam tube (2) as well as a focusing system for focusing an ion beam,
- a sample transfer system, comprising a sample manipulator with a sample holder for receiving at least one sample,
***characterized in that***
the device has a coupling system (1) in the form of a joint vacuum feedthrough for the vacuum-sealed connection of the ion beam tube (2) to the measurement chamber (3),
- which comprises an ion beam vacuum feedthrough, at least one means for receiving the at least one detector, at least one means for receiving the observation mirror and/or the camera as well as a means for receiving the sample transfer system, wherein the detector, the observation mirror and/or the camera and the sample transfer system are each connected to the coupling system via the aforementioned receiving means,
- and thus represents a mechanical connection between the components ion optics, detector, observation mirror and/or camera and sample transfer system, thereby enabling small distances and a precise alignment between the last ion-optical component of the focusing system, the sample to be examined and the detector.

2. The device according to preceding claim 1, with a coupling system (1) comprising a two-stage joint with lateral and transversal flexibility.

3. The device according to any one of the preceding claims 1 to 2, with a detector for at least two particle types or particle stopping power.

4. The device according to any one of the preceding claims 1 to 3, with a circular detector with a central bore.

5. The device according to any one of the preceding claims 1 to 4, with a sample observation which has a telecentric camera as well as a deflecting mirror.

6. The device according to any one of the preceding claims 1 to 5,
with a means for correcting the sample surface-to-detector distance in the installed state.

7. The device according to any one of the preceding claims 1 to 6, with a vacuum system comprising vacuum measurement and vacuum analysis devices.

8. The device according to any one of the preceding claims 1 to 7, with a nonmagnetic sample manipulator.

## Revendications

1. Dispositif d'analyse de faisceau ionique à base de MeV d'un échantillon, comprenant
- une chambre (3) de mesure sous vide ayant au moins un détecteur et un miroir d'observation et/ou une caméra d'observation d'échantillon,
- un système à vide de production d'un vide dans la chambre de mesure sous vide,
- un tube (2) de faisceau ionique ainsi qu'un système de focalisation pour la focalisation d'un faisceau ionique,
- un système de transfert d'échantillon, comprenant un manipulateur d'échantillon ayant une fixation d'échantillon pour la réception d'au moins un échantillon,
***caractérisé en ce que***
le dispositif a un système (1) d'injection sous la forme d'une articulation - passage à vide pour le raccordement d'une manière étanche au vide du tube (2) de faisceau ionique à la chambre (3) de mesure,
- qui comprend un passage à vide du faisceau ionique, au moins au moyen de réception du au moins un détecteur, au moins un moyen de réception du miroir d'observation et/ou de la caméra, ainsi qu'au moins un moyen de réception du système de transfert d'échantillon, dans lequel le détecteur, le miroir d'observation et/ou la caméra et le système de transfert d'échantillon sont reliés au système d'injection respectivement par le moyen de réception mentionné précédemment,
- et représente ainsi une liaison mécanique entre les pièces optique ionique, détecteur, miroir d'observation et/ou caméra et système de transfert d'échantillon, grâce à quoi des distances petites et une orientation précise entre la dernière pièce d'optique ionique du système de focalisation, l'échantillon à examiner et le détecteur sont rendues possibles.

2. Dispositif suivant la revendication 1 précédente, comprenant un système (1) d'injection comprenant une articulation à deux étages ayant de la souplesse latérale et transversale.

3. Dispositif suivant l'une des revendications 1 à 2 précédentes, comprenant un détecteur d'au moins deux types de particules ou une capacité de freinage des particules.

4. Dispositif suivant l'une des revendications 1 à 3 précédentes, comprenant un détecteur circulaire ayant un trou central.

5. Dispositif suivant l'une des revendications 1 à 4 précédentes, comprenant une observation d'échantillon, qui a une caméra télécentrée, ainsi qu'un miroir de déviation.

6. Dispositif suivant l'une des revendications 1 à 5 précédentes, comprenant un moyen de correction de la distance de la surface de l'échantillon au détecteur à l'état monté.

7. Dispositif suivant l'une des revendications 1 à 6 précédentes, comprenant un système à vide comprenant des appareils de mesure du vide et d'analyse du vide.

8. Dispositif suivant l'une des revendications 1 à 7 précédentes comprenant un manipulateur d'échantillon amagnétique.
